# Europäisches Patentamt
# European Patent Office
# Office européen des brevets

(19)

(11) Veröffentlichungsnummer: **0 003 030**
**B1**

(12) **EUROPÄISCHE PATENTSCHRIFT**

(45) Veröffentlichungstag der Patentschrift: **21.10.81**

(21) Anmeldenummer: **78101635.7**

(22) Anmeldetag: **09.12.78**

(51) Int. Cl.³: **G 11 C 11/24,**
**G 11 C 11/34, H 01 L 27/06**

(54) Dynamische bipolare Speicherzelle.

(30) Priorität: **30.12.77 US 866126**

(43) Veröffentlichungstag der Anmeldung:
**25.07.79 Patentblatt 79/15**

(45) Bekanntmachung des Hinweises auf die Patenterteilung:
**21.10.81 Patentblatt 81/42**

(84) Benannte Vertragsstaaten:
**DE FR GB NL SE**

(73) Patentinhaber: **International Business Machines Corporation**
**Armonk, N.Y. 10504 (US)**

(72) Erfinder: **El-Kareh, Badih**
**RFD No. 2 Westford Road**
**Milton Vermont 05468 (US)**
Erfinder: **Gersbach, Edwin John**
**500 South Willard Street**
**Burlington Vermont 050401 (US)**
Erfinder: **Houghton, James Russell**
**40 Pleasant Street**
**Essex Junction Vermont 05452 (US)**

(74) Vertreter: **Rudolph, Wolfgang**
**Schönaicher Strasse 220**
**D-7030 Böblingen (DE)**

(56) Entgegenhaltungen:
FR - A - 2 358 024
US - A - 3 697 962
US - A - 3 715 732
US - A - 3 729 719
US - A - 3 815 106
US - A - 3 827 034
US - A - 3 898 483
US - A - 3 931 617
US - A - 3 949 243
US - A - 4 003 076

IBM TECHNICAL DISCLOSURE BULLETIN, vol. 19, nr.8, Januar 1977
Armonk, USA.
HO & RISEMAN. "Dynamic Random-Access Memory", Seiten 3060—3062

IBM TECHNICAL DISCLOSURE BULLETIN, vol.14, nr.11, April 1972
Armonk, USA.
HENLE et al. "Nondestructive Read and Regeneration, Dynamic SCR Memory", Seite 3243

IBM JOURNAL OF RESEARCH AND DEVELOPMENT, vol.16, nr.1, Januar 1972
Armonk, USA.
JUTZI & SCHUENEMANN: "Cross-coupled Thyristor Storage Cell", Seiten 35—44

IBM TECHNICAL DISCLOSURE BULLETIN, vol.14, nr.5, Oktober 1971
Armonk, USA.
GATES et al. "Capacitor-extended Subcollector and Extended Transistor Subcollector", Seiten 1652—1653

Courier Press, Leamington Spa, England.

## Dynamische bipolare Speicherzelle

Die Erfindung betrifft eine dynamische bipolare Speicherzelle, bestehend aus zwei komplementären, nach Art einer Vierschicht-Speicherzelle jeweils zwischen Basis und Kollektor verbundenen Transistoren, die im Kreuzungspunkt von Ansteuerleitungen zum Treiben und Abfühlen zwecks Schreiben und Lesen liegen, bei der der PNP-Transistor als Lesetransistor und der NPN-Transistor als Schreibtransistor geschaltet ist, bei der parallel zur Emitter-Basisstrecke des Lesetransistors eine erste Kapazität liegt, und parallel zur Basis-Kollektorstrecke des NPN-Transistors eine zweite Kapazität liegt. Eine derartige Speicherzelle ist aus der US—A— 3 715 732 bekannt.

Eine bipolare Speicherzelle, bestehend aus zwei komplementären, nach Art einer Vierschicht-Zelle, jeweils zwischen Basis und Kollektor verbundenen Transistoren, die dynamisch betrieben wird, ist bereits aus der DE—A— 21 55 228 bekannt. Diese Speicherzelle ist dadurch charakterisiert, daß der eine gemeinsame Basis-Kollektoranschluß an eine erste Ansteuerleitung angeschlossen ist, über die ein Kippvorgang unterdrückt wird, und daß die beiden Emitteranschlüsse mit zugeordneten zweiten und dritten Ansteuerleitungen verbunden sind, über die der Speichervorgang als Auf- und Entladung der Basis-Kollektorkapazität der Transistoren erfolgt. Das Auslesen erfolgt über eine dritte Ansteuerleitung durch Anheben des Potentials auf der ersten Ansteuerleitung, wobei der erste Transistor in Abhängigkeit vom Ladezustand der Basis-Kollektorkapazität leitend oder gesperrt ist, was einer gespeicherten Null bzw. Eins entspricht, je nach Zuordnung. Außerdem ist durch die prioritätsgleiche DE—C 21 56 805 eine weitere dynamische Speicherzelle bekannt geworden, die zwar hinsichtlich der Schaltung der Speicherzelle und der Betriebsweise im wesentlichen mit der bereits beschriebenen übereinstimmt, sich jedoch in der monolithischen Struktur unterscheidet. Bei dieser Speicherzelle ist das erste Halbleiterbauelement ein PNP-Transistor, an dessen Emitter die Schreibleitung angeschlossen ist, dessen Kollektor mit der Basis des als Ausgangstransistor dienenden zweiten Halbleiterbauelements vom NPN-Typ verbunden ist und dessen Basis sowohl an den Kollektor des NPN-Ausgangstransistors als auch, eine gemeinsame Lese- und Datenleitung angeschlossen ist, und bei dem die parasitäre Kapazität zwischen der Verbindung des Kollektors des Eingangstransistors mit der Steuerelektrode des Ausgangstransistors unter Verbindung des Kollektors des Ausgangstransistors mit der Steuerelektrode des Eingangstransistors liegt.

Obwohl sich beide Speicherzellen durch einen geringen Platzbedarf auszeichnen und auch sehr schnelle Schaltzeiten erreicht werden, haben sie jedoch den Hauptnachteil, daß sie durch die Verwendung der Basis-Kollektor-Verbindung sowohl des PNP-als auch des NPN-Transistors eine sehre kleine Kapazität zur Informationsspeicherung aufweisen. Dies wiederum hat den Nachteil, daß das Ausgangssignal in seiner Amplitude äußerst klein ist, so daß der Abstand zwischen dem Eins- und dem Null-Signal mit relativ hohem technischen Aufwand festzustellen ist.

Außerdem ist aus der US—A—3 715 732 eine dynamische bipolare Speicherzelle bestehend aus einem PNP-Transistor und einem NPN-Transistor bekannt, bei der der PNP-Transistor als Lesetransistor und der NPN-Transistor als Schreibtransistor geschaltet ist und bei der ein Punkt zwischen der Basis des Lesetransistors und dem Kollektor des Schreibtransistors mit einer ersten Kapazität verbunden ist, die über der Basis-Emitterstrecke des Lesetransistors liegt und der weiterhin mit einem zweiten Kondensator verbunden ist, der über der Basis-Kollektorstrecke des Schreibtransistors liegt.

Außerdem ist aus der FR—A 2 358 024 der Aufbau einer integrierter Thyristorschaltung bekannt, bei der eine epitaxiale Insel innerhalb der Epitaxieschicht, oberhalb der Subkollektorregion und unterhalb zweier P-Typ-Regionen angeordnet ist und bei der in einer der P-Typ-Regionen eine N-Typ-Diffusion liegt, die durch ein Fenster in einer Schicht aus Siliciumdioxid eingebracht ist.

Auch hier ist die zur eigentlichen Speicherung erforderliche Kapazität zu klein, um ein genügend großes Ausgangssignal zu erzeugen, damit die peripheren Schaltkreise für einen Speicher nicht technisch zu aufwendig werden.

Der Erfindung liegt deshalb die Aufgabe zugrunde, eine verbesserte dynamische bipolare Speicherzelle der oben genannten Art zu schaffen, die ein höheres Ausgangssignal sowie einen größeren Abstand zwischen dem Null- und dem Eins-Signal ermöglicht, indem die zur eigentlichen Informationsspeicherung erforderliche Kapazität ohne Vergrößerung des Platzbedarfs und ohne Verschlechterung der Parameter einer derartigen Speicherzelle zu erhöhen ist.

Die erfindungsgemäße Lösung besteht nun darin, daß der Speicher- oder Ladungspunkt zwischen der Basis des Lesetransistors und dem Kollektor des Schreibtransistors angeordnet ist, daß der Speicherpunkt mit der ersten und der zweiten Kapazität und weiterhin mit einer dritten Kapazität verbunden ist, die außerdem mit einem festen Potential verbunden ist, und daß ein Punkt der Verbindungsleitung zwischen Kollektor des Lesetransistors und Basis des Schreibtransistors über die Bitleitung mit einem kombinierten Abfühlverstärker/Bittreiber verbunden ist, daß der Emitter des Schreibtransistors mit einem Schreibtreiber verbunden ist und daß ein Punkt der Verbindungsleitung zwischen Emitter des Lesetransistors und dem ersten Kondensator mit einem Lesetreiber verbunden ist.

Eine besondere Ausführungsart der Erfindung besteht darin, daß die Kapazität des ersten Kondensators und des zweiten Kondensators klein im Verhältnis zur Kapazität des dritten Kondensators ist, wobei vorzugsweise die Kapazität des dritten Kondensators 4 bis 5 mal größer also die Kapazität des ersten Kondensators ist.

Dadurch, daß in der vorliegenden Zelle der PNP-Transistor als Lesetransistor dient, der mit dem NPN-transistor als Schreibtransistor gekoppelt ist, wird eine wesentlich größere Kapazität zur Informationsspeichergung erreicht als bisher. Aufgrund der größeren Speicherkapazität ergibt sich auch beim Lesen ein wesentlich höheres Ausgangssignal und ein größerer Abstand des Null- und Eins-signals beim Auslesen. Hinzu kommt noch, daß eine derartige Schaltung in einer monolithischen Struktur verwirklicht werden kann, die sogar noch zu einer höheren Integrationsdichte als bisher führt. Da die Speicherzelle in einem integrierten monolithischen Halbleiterspeicher auch leicht ansteuerbar ist, und die Schreibzeit mindestens genau so hoch liegt wie bisher, außerdem keine komplizierten Prozeßschritte zu seiner Herstellung erforderlich sind, ist durch die vorliegende lösung ein sehr wichtiger Schritt zur Erhöhung der Integrationsdichte bei gleichzeitiger Erhöhung der Betriebssicherheit erzielt worden. Die höhere Integrationsdichte innerhalb eines monolithischen Speichers ergibt sich auch noch daraus, daß die peripheren Schaltkreise zum Abfühlen und Lesen für die vorliegende Speicherzelle sich im Vergleich zu denen, die für die zum Stand der Technik gehörenden Speicherzellen erforderlich sind, wesentlich verringern, was besonders deshalb vorteilhaft ist, weil die peripheren Schaltkreise bei einem monolithischen Speicher einen nicht unerheblichen Teil der Substratfläche in Anspruch nehmen.

Die Erfindung wird nun anhand eines in den Zeichnungen dargestellten Ausführungsbeispiels näher beschrieben.

Es zeigen:

Fig. 1 eine Draufsicht auf eine monolithische Struktur der erfindungsgemäßen bipolaren Speicherzelle;

Fig. 2 eine Schnittansicht der Struktur der Speicherzelle entlang der Schnittlinie 2 in Fig. 1;

Fig. 3 die Schaltung und die verschiedenen Impulsspannungen, die zum Betrieb der Speicherzelle erforderlich sind und,

Fig. 4 ein Impulsdiagramm, in dem alle wichtigen Spannungsverläufe beim Schreiben und Lesen der Speicherzelle nach den Fign. 1 bis 3 eingezeichnet sind.

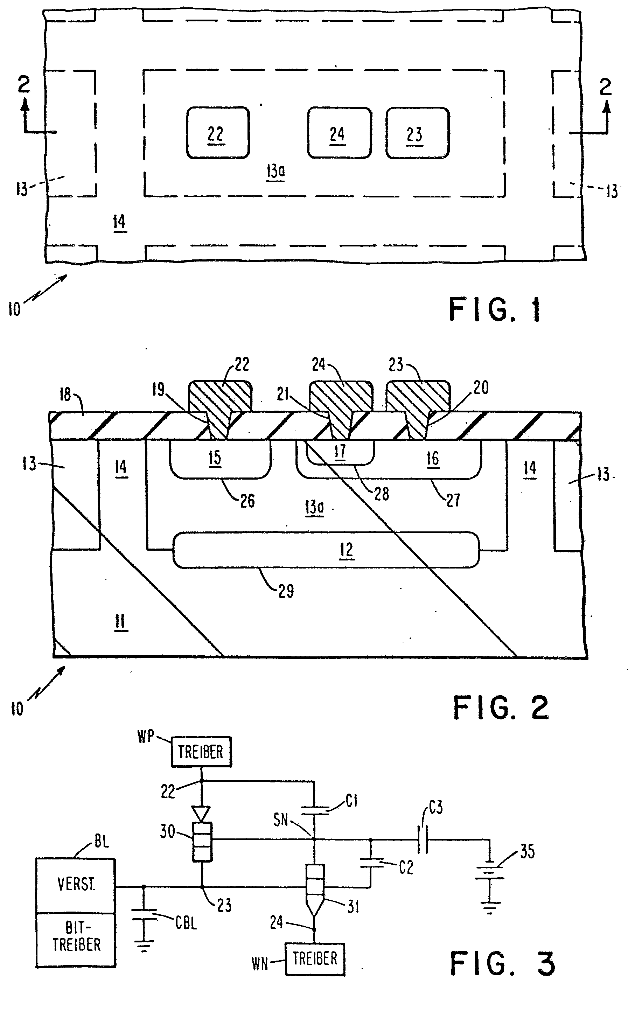

Zunächst wird anhand der Fign. 1 und 2 der strukturelle Aufbau der Speicherzelle beschrieben, die in den beiden Figuren als eine einzeln isolierte Zelle 10 dargestellt ist und zwar unter Verwendung bekannter Halbleitertechniken.

Ein Substrat 11 vom P-Typ mit einem spezifischen Widerstand von 10 Ohm/cm wird zur Bildung eines Subkollektors 12 einer normalen Diffusionstechnik unterzogen. Nach der Bildung des Subkollektors 12 wird auf das Substrat 11 eine Epitaxieschicht 13 aufgewachsen. Nachdem diese Schicht 13 bis zur erforderlichen Dicke z.B. 5 $\mu$m, aufgewachsen ist, wird die Einheit einer Ionenimplantation unterzogen, um ein P-leitendes Isolationsmuster 14 herzustellen. Die so geformte Isolationsregion durchdringt das Gebilde nach den Fign. 1 und 2 so weit wie die Epitaxialschicht 13 reicht, um mit dem Substrat 11 zu verschmelzen und die Subkollektorregion 12 zu isolieren und eine Insel 13A in der Epitaxialschicht 13 oberhalb des Subkollektors 12 zu definieren und zu isolieren. Diese definierte Insel- und Subkollektorkombination ist völlig durch einen PN-Übergang 29 eingeschlossen, der zwischen der Isolationsregion und der Insel 13A und dem Subkollektor 12 und dem Substrat 11 liegt.

Danach werden an der Oberfläche der Insel 13A zwei Regionen 15 und 16 vom P-Typ gebildet. Die Region 15 bildet einen PN-Übergang 26 mit der darunterliegenden Epitaxie-Insel 13a. Die Region 16 bildet einen ähnlichen PN-Übergang 27 mit der Insel 13a. Darauffolgend wird eine Diffusion 17 vom N-Typ in die Diffusion 16 eingebracht, um einen PN-Übergang 28 mit der Region 16 zu bilden. Nachdem diese Diffusionen abgeschlossen sind, wird die Oberfläche der Anordnung mit einer Schicht 18 von Siliciumdioxid mit einer Schichtdicke von 3000 Å überzogen. Durch diese Schicht werden drei verschiedene Fenster 19, 20 und 21 genau über den entsprechenden Diffusionen 15, 16 und 17 gebildet. Danach wird ein leitendes Material, z.B. Aluminium in die Fenster eingebracht, um die darunterliegenden Regionen 15, 16 und 17 zu kontaktieren.

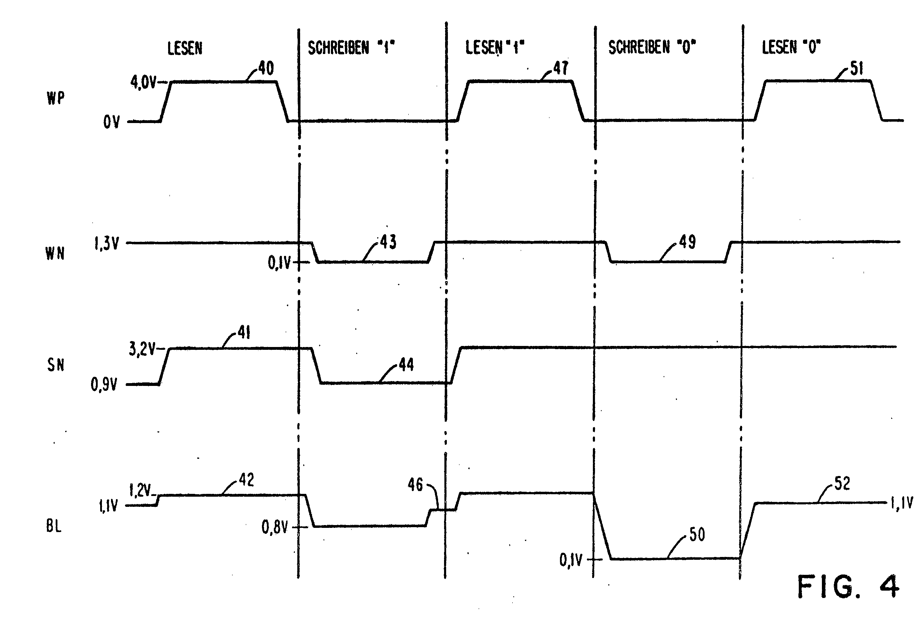

Der PNP-Transistor 30, der schematisch in Fig. 3 zu sehen ist, besteht aus der Region 15, die als Emitter dient, aus der Region 13a, die als Basis dient und aus der Region 16, die als Kollektor dient.

Der PNP-Transistor 31 ist durch die Region 17, die als Emitter dient, die Region 16, die als Basis dient und die Region 13a, welche gemeinsam mit dem Subkollektor 12 als Kollektor dient, definiert.

Wenn die dargestellte Speicherzelle innerhalb einer Speichermatrix arbeiten soll, dann ist es erforderlich, daß ein Treiber WP an den Anschlußpunkt 22 der Leseleitung angeschlossen wird. Diese Verbindungen sind u.a. in Fig. 3 dargestellt. Ein zweiter Treiber WN ist mit dem Anschlußpunkt 24 der Schreibleitung verbunden. Diese Treiberschaltungen sind nicht Gegenstand der vorliegenden Erfindung und werden deshalb auch nicht näher beschrieben;

es können vielmehr bekannte Treiberschaltkreise verwendet werden, die die entsprechenden Spannungen und Ströme zur Verfügung stellen können. Wie aus Fig. 3 zu ersehen ist, wird der PNP-Transistor 30 als Lesetransistor und der NPN-Transistor 31 als Schreibtransistor verwendet. An den Anschlußpunkt 23, der hier als Anschlußpunkt für die Bitleitung dargestellt ist, ist ein weiterer bekannter Abfühl-/Bittreiber angeschlossen, der beim Schreiben die Bitleitungen treibt und beim Lesen die gespeicherte Information über die Bitleitung abfühlt.

Die Kapazität C1, die parallel zu Emitter und Basis des PNP-Transistors 30 dargestellt ist, stellt die Kapazität des Pn-Übergangs 26 in Fig. 2 dar.

Die Kapazität C2, die parallel zur Basis und den Kollektor des NPN-Transistors 31 eingezeichnet ist, stellt die Kapazität des PN-Übergangs 27 in Fig. 2 dar und die Kapazität C3 in Fig. 3 stellt die Kapazität des PN-Übergangs 29 dar, die den Subkollektor 12 und die Insel 13a einschließt. Das Substrat 11 ist mit einem festen Potential aus einer Batterie 35 verbunden. Jeder der Kondensatoren C1, C2 und C3 hat mit einem seiner Anschlüsse einen gemeinsamen Referenzpunkt, z.B., wie im vorliegenden Falle, die epitaxiale Insel 13a, in der im vorliegenden Ausführungsbeispiel die Information gespeichert ist.

Die Kapazitäten C1 und C2 sind im Verhältnis zur Kapazität C3 beide sehr klein. Die Kapazität C3 ist typischerweise vier bis fünf mal größer als die Kapazität C1. Die Kapazitäten C1 und C2 haben beide die gleichen Eigenschaften, weil sie als Verarmungskapazitäten zwischen gleichzeitig diffundierten P-Regionen 15 und 16 und der definierten epitaxialen Insel 13a vom N-Typ Material liegen.

Die Region 13a, die den Ladungsspeicher enthält, ist schematisch bei dem gemeinsamen Punkt SN der drei Kondensatoren bzw. Kapazitäten C1, C2 und C3 dargestellt.

Die Verwendung dieser Region der Zelle als Speicherpunkt hat eine Anzahl von sehr großen Vorteilen, die die bisher bekanntgewordenen Speicherzellen dieser Art nicht aufweisen.

Da die Kapazität C3 größer als die Kapazitäten der Kondensatoren C1 und C2 sind, hat eine derartige Speicherzelle eine wesentlich bessere Amplitude des Ausgangssignals und ein vorzügliches Verhältnis des Null-Signals zum Eins-Signal. Außerdem hat eine derartige Speicherzelle eine wesentlich kleinere Bitleitungskapazität CBL und weniger Signaldämpfung.

Da die erfindungsgemäße Speicherzelle den PNP-Transistor als Lesespeicher verwendet und während des Lesens einer Eins beide Kapazitäten C2 und C3 parallel betreibt, ergibt sich ein signifikat größeres abgefühltes Signal im Verhältnis zu den bisher bekanntgewordenen Speicherzellen. Zusätzlich wird durch die Verwendung des PNP-Transistors als Lesetransistor bedeutend weniger Ladung benötigt, um den PNP-Transistor einzuschalten. Dies ergibt sich daraus, daß das Verhältnis der Kapazität C1 zu der Kapazität (C2 + C3) sehr klein ist und zum anderen der PNP-Lesetransistor einschaltet, wodurch die Spannung über den Kondensator C1 nicht mehr, hervorgerufen durch die Eigenschaften des Emitter-Basisübergangs 26 des PNP-Transistors, laufend wechselt. Während des Lesens der Speicherzelle scheint die Kapazität C1 in der Schaltung praktisch nicht auf und beeinflußt in keiner Weise die Betriebsweise.

Außerdem wird durch die Verwendung des NPN-Transistors als Schreibtransistor die Schreiboperation wesentlich schneller als bei den bisher bekanntgewordenen. Dies resultiert daraus, daß die NPN-Transistoren eine signifikant bessere Grenzfrequenz als die PNP-Transistoren aufweisen.

Da die Leseoperation in diesen Zellen informationszerstörend ist, ist es erforderlich, den Zustand der Speicherzelle zu regenerieren, oder die ausgelesene Information wiedereinzuschreiben nach Beendigung einer jeden Leseoperation.

In Verbindung mit dem Impulsdiagramm nach Fig. 4 wird nun im folgenden eine Lese und eine Schreiboperation der Speicherzelle nach den Fign. 1 bis 3 näher beschrieben.

Für dieses Beispiel sei angenommen, daß der Speicherpunkt SN effektiv entladen ist, wenn dieser bei 0,9 Volt liegt.

Da die Leseoperation informationszerstörend ist, wird vor dem Betrieb des Speichers eine Leseoperation durchgeführt, um sicherzustellen, daß sich die Speicherzelle in einem bestimmten bekannten Zustand befindet.

Während des Lesens wird der Treiber WP verursacht, das Potential von 0 Volt auf 4,0 Volt ansteigen zu lassen, wodurch ein positiver 4 Volt-Impuls 40 am Punkt 22 und am Emitter des PNP-Transistors 30 erscheint. Gleichzeitig wird der Treiber WN auf einem Potential von 1,3 Volt gehalten. Durch diese angelegten Potentiale wird der PNP-Transistor 30 eingeschaltet und ein Ladungsfluß über den PNP-Emitter-Basisübergang erzeugt, wodurch der Speicherpunkt SN veranlaßt wird, von seinem entladenen Zustand von 0,9 Volt in seinen geladenen Zustand von 3,2 Volt überzugehen. Dieser Wechsel ist im Diagramm als Impuls 41 gezeigt. Da der Leseimpuls 40 bei 4,0 Volt verbleibt, nachdem der Speicherpunkt SN 3,2 Volt erreicht, verbleibt der Transistor 30 eingeschaltet und ein Ladungsfluß über dem Kollektor des PNP-Transistors 30 lädt die Bitleitung von 1,1 Volt auf 1,2 Volt, wie durch den Impuls 42 dargestellt. Dieser Spannungssprung auf der Bitleitung wird durch den Abfühlverstärker BL an der Bitleitung abgefühlt. Da der Ladungsfluß über den Emitter-Basisübergang des PNP-Transistors gleich dem Wert: $\beta$ des PNP-Transistors mal der Ladung, die zu seiner Basis übertragen ist, beträgt, kann die Zelle wesentlich kleiner gemacht werden. Da die Kapazitäten ebenfalls kleiner gemacht werden können, stellt die $\beta$-Verstärkung sicher, daß ein abfühlbares Signal realisiert werden kann. Die Leseoperation wird durch puls 40 beendet, der die Spannung des Treibers WP zurück zu 0 Volt bringt. Die Schreiboperation für eine Eins wird initialisiert durch Schalten des Treibers WP auf 0 Volt und setzen der Bitleitung auf 0,8 Volt durch den Bittreiber und durch Herunterziehen des Treibers WN von 1,3 Volt auf 0,1 Volt, was durch den Impuls 30 dargestellt ist. Dadurch wird verursacht, daß der Transistor 30 leitend wird und der Speicherpunkt SN auf 0,9 Volt entladen wird, wie durch den Impuls 44 gezeigt. Wenn der Impuls 43 beendet ist und die Spannung am Schreibtreiber WN auf, 1,3 Volt zurückgeht, wird die Spannung auf der Bitleitung auf 1,1 Volt zurückgesetzt, was durch den kleinen Sprung bei 46 im Diagramm nach Fig. 4 gezeigt ist und durch den Bittreiber BL angezeigt wird. Durch die Entladung des Speicherpunktes SN ist somit eine Eins in die Speicherzelle eingeschrieben worden.

Es wird nun angenommen, daß dem Einschreiben einer Eins das Auslesen einer Null aus der Speicherzelle folgt. Dazu wird ein 4 Volt-Impuls 47 vom Lesetreiber WP abgegeben, während der Schreibtreiber WN weiterhin eine Spannung von 1,3 Volt abgibt. Dadurch wird der Speicherpunkt SN aufgeladen und erreicht eine Spannung von 3,2 Volt. Gleichzeitig beginnt die Auflading der Bitleitung auf 1,2 Volt. Der Sprung um 0,1 Volt auf der Bitleitung, der vom Abfühlverstärker an der Bitleitung abgefühlt wird, zeigt an, daß eine Eins darin gespeichert war.

Dadurch, daß die Leseoperation zerstörend wirkt, wird der Speicherpunkt SN auf 3,2 Volt aufgeladen, was effektiv dem Einschreiben einer Null in die Speicherzelle entspricht. Aufgrund der Eigenschaften der Speicherzellen in dem beschriebenen Ausführungsbeispiel ist es erforderlich, daß einem Lesezyklus ein Schreibzyklus folgt. In diesem Falle wird angenommen, daß eine Null einzuschreiben ist. Der Lesetreiber WP wird deshalb auf 0 Volt gehalten und der Schreibtreiber wird auf 0,1 Volt gepulst, was durch den Impuls 49 im Diagramm nach Fig. 4 gezeigt ist. Da die Bitleitung im vorliegenden Falle durch den Bittreiber (Impuls 50) bei 0,1 Volt gehalten wird, wird der PNP-Transistor 31 nicht eingeschaltet und dadurch erfolgt kein Wechsel im Zustand des Speicherpunkts SN, und zwar deshalb, weil vorher eine Eins ausgelesen wurde und die Spannung bei 3,2 Volt verbleibt. Um sicherzustellen, daß der NPN-Transistor 31 nicht eingeschaltet wird und eine Eins nicht eingeschrieben wird, ist das Potential auf der Bitleitung auf 0,1 Volt herabzuziehen. Wenn der Schreibtreiberimpuls 49 beendet ist, ist die Bitleitung BL wieder auf 1,1 Volt durch den Bittreiber aufgeladen worden.

Um die gespeicherte Null zu lesen, wird der Lesetreiber WP auf 4 Volt (Impuls 51) hochgepulst. Da der Speicherknoten SN vollgeladen ist, schaltet der Transistor 30 nicht ein und es erfolgt keine Änderung im Ladungszustand des Speicherpunkts oder des Zustands auf der Bitleitung, wodurch angezeigt wird, daß eine Null in der Speicherzelle gespeichert ist.

## Patentansprüche

1. Dynamische bipolare Speicherzelle, bestehend aus zwei komplementären, nach Art einer Vierschicht-Speicherzelle jeweils zwischen Basis und Kollektor verbundenen Transistoren, die im Kreuzungspunkt von Ansteuerleitungen zum Treiben und Abfühlen zwecks Schreiben und Lesen liegen, bei der der PNP-Transistor (30) als Lesetransistor und der NPN-Transistor (31) als Schreib-transistor geschaltet ist, bei der parallel zur Emitter-Basisstrecke des Lesetransistors eine erste Kapazität (C1) liegt, und parallel zur Basis-Kollektorstrecke des NPN-Transistors eine zweite Kapazität (C2) liegt, dadurch gekennzeichnet, daß der Speicheroder Ladungspunkt (SN) zwischen der Basis des Lesetransistors (30) und dem Kollektor des Schreibtransistors (31) angeordnet ist, daß der Speicherpunkt (SN) mit der ersten und der zweiten Kapazität und weiterhin mit einer dritten Kapazität (C3) verbunden ist, die außerdem mit einem festen Potential (35) verbunden ist, und daß ein Punkt (22) der Verbindungsleitung zwischen Kollektor des Lesetransistors und Basis des Schreibtransistors über die Bitleitung mit einem kombinierten Abfühlverstärker/Bittreiber (BL) verbunden ist, daß der Emitter des Schreibtransistors mit einem Schreibtreiber (WN) verbunden ist und daß ein Punkt (22) der Verbindungsleitung zwischen Emitter des Lesetransistors und dem ersten Kondensator (C1) mit einem Lesetreiber (WP) verbunden ist.

2. Dynamische bipolare Speicherzelle nach Anspruch 1, dadurch gekennzeichnet, daß die Kapazität des ersten Kondensators (C1) und des weiten Kondensators (C2) klein im Verhältnis zur Kapazität des dritten Kondensators (C3) ist.

3. Dynamische bipolare Speicherzelle nach den Ansprüchen 1 und 2, dadurch gekennzeichnet, daß die Kapazität des dritten Kondensators (C3) vier bis fünf mal größer als die Kapazität des ersten Kondensators (C1) ist.

4. Dynamische bipolare Speicherzelle nach den Ansprüchen 1 bis 3, dadurch gekennzeichnet, daß die Kondensatoren (C1 und C2) als Verarmungskapazitäten zwischen gleichzeitig-diffundierten P-Regionen (15 und 16) in eine definierte epitaxiale Insel (13a) vom N-Typ und diesen Inseln gebildet sind.

5. Dynamische bipolare Speicherzelle nach Anspruch 4, dadurch gekennzeichnet, daß die epitaxiale Insel (13a) der als Ladungsspeicher gemeinsame Speicherpunkt (SN) der drei Kondensatoren (C1, C2 und C3) ist.

6. Dynamische bipolare Speicherzelle nach den Ansprüchen 1 bis 5, dadurch gekennzeichnet, daß die epitaxiale Insel (13a) innerhalb der Epitaxieschicht (13), oberhalb der Subkollektorenregion (12) und unterhalb zweier p-Typ-Regionen (15, 16) angeordnet ist, und daß in einer der p-Typ-Regionen (16) eine N-Typ-Diffusion (17) liegt, die durch ein Fenster in einer Schicht aus Siliciumdioxid eingebracht ist.

## Claims

1. Dynamic bipolar memory cell consisting of two complementary transistors connected in the manner of a silicon-controlled rectifier between base and collector, which are arranged at the cross point of address lines for driving and sensing for the purpose of writing and reading, wherein the PNP transistor (30) and the NPN transistor (31) are respectively switched as a read and a write transistor, wherein a first capacitance (C1) lies parallel to the emitter-base path of said read transistor and a second capacitance (C2) lies parallel to the base-collector path of said NPN transistor, characterized in that the storage or charge node (SN) is arranged between the base of said read transistor (30) and the collector of said write transistor (31), that said storage node (SN) is connected to said first and said second capacitance and furthermore to a third capacitance (C3) which is also connected to a fixed potential (35), and that a node (22) of the interconnecting line between collector of said read transistor and base of said write transistor is connected to a combined sense amplifier/bit driver (BL) via the bit line, that the emitter of said write transistor is connected to a write driver (WN), and that a node (22) of the interconnecting line between emitter of said read transistor and said first capacitor (C1) is connected to a read driver (WP).

2. Dynamic bipolar memory cell according to claim 1, characterized in that the capacitance of said first capacitor (C1) and said second capacitor (C2) is small in relation to the capacitance of said third capacitor (C3).

3. Dynamic bipolar memory cell according to claims 1 and 2, characterized in that the capacitance of said third capacitor (C3) is four to five times larger than the capacitance of said first capacitor (C1).

4. Dynamic bipolar memory cell according to claims 1 to 3, characterized in that said capacitors (C1 and C2) are formed as depletion capacitances between P-type regions (15 and 16) simultaneously diffused into a defined N-type epitaxial island (13a) and said island.

5. Dynamic bipolar memory cell according to claim 4, characterized in that said epitaxial island (13a) is the common storage node (SN) of said three capacitors (C1, C2 and C3) serving as a charge storage.

6. Dynamic bipolar memory cell according to claims 1 to 5, characterized in that said epitaxial island (13a) in said epitaxial layer (13) is arranged above the subcollector region (12) and below two P-type regions (15, 16), and that one of said P-type regions (16) comprises an N-type diffusion (17) introduced through a window into a layer of silicon dioxide.

## Revendications

1. Cellule de mémoire dynamique bipolaire composée de deux transistors complémentaires chacune ayant sa base connectée au collecteur de l'autre à la façon d'une cellule de mémoire à quatre couches, qui sont disposés au point d'intersection des lignes d'adresse pour commander et détecter l'écriture et al lecture, dans laquelle le transistor PNP (30) et le transistor NPN (31) sont montés en transistor de lecture et en transistor d'écriture respectivement, dans laquelle un premier condensateur (C1) est en parallèle avec le trajet émetteur-base du transistor de lecture et un second condensateur (C2) est en parallèle avec le trajet base-collecteur du transistor NPN, caractérisée en ce que le noeud de stockage ou de charge (SN) est disposé entre la base du transistor de lecture (30) et le collecteur du transistor d'écriture (31), en ce que le noeud de stockage (SN) est connecté aux premier et second condensateurs et en outre à un troisième condensateur (C3) qui est également connecté à un potentiel fixe (35), et en ce qu'un noeud (22) de la ligne d'interconnexion entre le collecteur du transistor de lecture et la base du transistor d'écriture est connecté, à travers la ligne de bit, à un amplificateur de détection/circuit de commande bit (BL), en ce que l'émetteur du transistor d'écriture est connecté à un circuit de commande d'écriture (WN), et en ce qu'un noeud (22) de la ligne d'interconnexion entre l'émetteur du transistor de lecture et le premier condensateur (C1) est connecté à un circuit de commande de lecture (WP).

2. Cellule de mémoire dynamique bipolaire selon la revendication 1, caractérisée en ce que les capacités du premier condensateur (C1) et du second condensateur (C2) sont faibles par rapport à la capacité du troisième condensateur (C3).

3. Cellule de mémoire dynamique bipolaire selon l'une quelconque des revendications 1 et 2, caractérisée en ce que la capacité du troisième condensateur (C3) est quatre à cinq fois plus élevée que la capacité du premier condensateur (C1).

4. Cellule de mémoire dynamique bipolaire selon l'une quelconque des revendications 1 à 3, caractérisée en ce que les condensateurs (C1 et C2) sont constitués par des capacités d'appauvrissement entre des régions du type P (15 et 16) diffusées simultanément dans un îlot épitaxial défini (13a) du type N et ces îlots.

5. Cellule de mémoire dynamique bipolaire selon la revendication 4, caractérisée en ce que l'îlot épitaxial (13a) constitue le noeud de stockage commun (SN) des trois condensateurs (C1, C2 et C3), servent de mémoire de charge.

6. Cellule de mémoire dynamique bipolaire selon l'une quelconque des revendications 1 à 5, caractérisée en ce que l'îlot épitaxial (13a) dans la couche épitaxiale (13) est disposé au-dessus d'une région de sous-collecteur (12) et en-dessous de deux régions du type P (15, 16), et en ce que l'une des régions du type P (16) renferme un diffusion du type N (17) diffusée à travers une ouverture dans la couche de dioxyde de silicium.

FIG. 1

FIG. 2

FIG. 3

FIG. 4

0 003 030